# EUROPEAN PATENT APPLICATION

(11) **EP 3 007 221 A1**
(43) Date of publication of application: **13.04.2016**
(21) Application number: 14803769.0
(22) Date of filing: 23.05.2014
(51) Int. Cl.: H01L 23/12, H01L 23/15, H05K 3/10, H05K 3/14, H05K 3/18, H05K 3/46

(54) **WIRING BOARD WITH THROUGH ELECTRODE, METHOD FOR PRODUCING SAME, AND SEMICONDUCTOR DEVICE**

(30) Priority: 31.05.2013 JP 2013116362
(71) Applicant: Toppan Printing Co., Ltd., Tokyo 110-0016 (JP)
(72) Inventor: YOSHIDA, Tomohiro, Tokyo 110-0016 (JP)
(74) Representative: Cabinet Plasseraud
(86) International application number: PCT/JP2014/002727
(87) International publication number: WO 2014/192270

(57) **Abstract**

A manufacturing method for forming a wiring board provided with a through electrode (8) includes steps of: a step for forming, to a first layer, a wiring layer (3) and a portion for a land (4) where the through electrode is provided, the wiring and the portion for the land being formed in glass (1); a step for forming a metal layer (6) on only a front surface of the glass; a step for forming a through hole in the glass only at a portion between the land where the through electrode of the back surface is provided and the land corresponding to the front surface thereof; a step for filling the through hole with a conductive material; a step for forming a metal layer (14) on the back surface; and a step for polishing the metal layer on the front and back surfaces of the glass until a glass surface is exposed.

## Description

### [Technical Field]

The present invention relates to, for example, a glass wiring board provided with a through electrode, and more particularly to a wiring board with a through electrode capable of being used for an interposer in which a wiring having adhesion to glass can be formed, having high reliability without voids in the through electrode and excellent electrical characteristics, a method for manufacturing the same and a semiconductor device.

### [Background]

Semiconductor elements manufactured by a wafer process, such as various memory devices, CMOS (complementary metal oxide semiconductor) or CPU (central processing unit) have terminals for electrical connection. A pitch of the terminals for the connection and a pitch of a connecting portion of a printed board which electrically connects semiconductor elements are usually several to several tens of times different in its scale. Therefore, when electrically connecting the semiconductor elements and the printed board, an intermediate board (semiconductor element mounted board) referred to as an interposer is used for converting the pitch. The semiconductor elements are mounted on one surface of the interposer and connected to the printed board on the other surface or around the board thereof.

As an interposer used for mounting the semiconductor elements on the printed board, an organic substrate or an organic build-up substrate have been used. However, because of the rapid growth of high performance electronic equipment such as smartphones nowadays, it is necessary to develop a 3-dimensional mounting technology or 2.5-dimensional mounting technology in which semiconductor elements are laminated vertically and different semiconductor elements such as a memory device and a logic device are arranged/ mounted on the same board. It is considered that these developments make it possible to further enhance high speed operation, high capacity and low power consumption of the electronic equipment. However, a precise wiring pattern is also required in the interposer because of the semiconductor elements being densified.

However, substrates using conventional organic material greatly expands and contracts due to moisture absorption and changes in temperature. Hence, a problem arises that a precise wiring pattern with scale matching is difficult to form.

Recently, a development of an interposer using silicon or glass as a base material is attracting attention. Since an influence of absorption and expansion/ contraction that cause a problem when using the organic substrate is not present, precise wiring pattern can be advantageously formed. Further, due to having high workability, a through electrode referred to as TSV (Through-Silicon Via) or TGV (Though-Glass Via) can be formed, in which fine through holes are formed internally and its holes are filled with conductive materials to form the TSV or TGV. The through electrodes are capable of shortening the wiring length so that the wirings of the substrate between the front surface and the back surface can be connected by the shortest distance. Therefore, excellent electrical characteristics such as high signal transmission speed can be achieved. Further, various advantages can be obtained, for example because of a structure in which wirings are formed internally, the mounting method is effective for shrinking/ highly densifying electronic devices, or parallel connection of multiple pins can be performed due to adoption of the through electrodes so that the LSI does not have to operate faster, thereby achieving low current consumption.

Comparing both interposers, a silicon interposer can be processed precisely rather than a glass interposer. Meanwhile, even processes for forming wirings and TSV has been established, since only silicon wafers having circular shape can be handled, the silicon interposer has significant disadvantages, because peripheral part of the wafer cannot be used and large sized objects cannot be manufactured at the same time, thereby increasing the manufacturing cost. In this respect, using the glass interposer, a large-scale processing can be performed with a large panel and also a manufacturing method using a roll-to-roll process can be adopted. Hence, the manufacturing cost can be significantly reduced. Moreover, unlike the TGV using a discharge method or a laser for penetration, the TSV requires gas etching to make through holes so that the processing period becomes longer and also requires a process for scraping the wafer, which increases the manufacturing cost.

Considering electrical characteristics, since the substrate of the glass interposer is made of an insulator which is different from the silicon interposer, even in a high speed circuit, parasitic elements are unlikely to appear. Thus, the glass interposer has better electrical characteristics. Since a formation step of an insulation film is not required when using glass for the substrate, the insulation properties are reliable so that the number of manufacturing steps can be reduced.

As described, by using the glass, the interposer can be produced at lower cost. However, as a significant disadvantage, since a process for forming precise wirings is not known and copper which is presently mainstream of the wiring materials of the glass does not adhere to the glass, a special process is required on the surface in order to form the wirings on the substrate. Further, since a through hole via-filling process is required to form the TGV, voids are likely to occur, which causes significant reliability issues.

For example, reference literature 1 and the like disclose a method using a glass interposer thereby enabling high density mounting. However, according to a technique of reference literature 1, although a glass interposer is employed in which precise copper wirings are formed compared to conventional organic resin, detailed description concerning the formation method of wirings is not disclosed. Hence, reference literature 1 is not sufficient.

Further, a method for forming a metal film on glass using nonelectrolytic plating without roughening is disclosed in patent literature 2 or the like. However, when making a plating film to be thicker in order to be used for wirings, there is a concern that peeling is likely to occur because the adhesive force is insufficient.

### [Citation List]

### [Patent Literature]

[PTL 1] Japanese Patent Application Laid-Open Publication No. 2003-249606
[PTL 2] Japanese Patent Application Laid-Open Publication No. H-10-209584

### [Summary]

### [Technical Problem]

The present invention has been achieved in light of the above-described issues and provides a wiring board capable of used for a glass interposer having high reliability, a method for manufacturing the same and a semiconductor device. The wiring board is produced in which a wiring layer of a first layer is embedded in a glass substrate so as to significantly enhance the adhesion, and only a through electrode portion is selectively embedded with a build up method by using electrolytic plating to form the TGVs, whereby occurrence of voids can be avoided.

### [Solution to Problem]

The invention according to claim 1 is a wiring board provided with a through electrode characterized in that the wiring board is multi-layered, having glass as a base material and a through electrode provided in the glass, in which a wiring layer and the through electrode in a first layer of front and back surfaces of the base material are formed in the glass.

The invention according to claim 2 is a wiring board provided with a through electrode according to claim 1 characterized in that, in the wiring board, a principal component of a through electrode portion is either Cu, Ag, Au, Ni, Pt, Pd, Ru, Fe or a compound containing these metals.

The invention according to claim 3 is characterized in that a manufacturing method for forming a wiring board provided with a through electrode includes steps of: a step for forming, to a first layer, a wiring and a portion for a land where the through electrode is provided, the wiring and the portion for the land being formed in glass; a step for forming a metal layer on only a front surface of the glass; a step for forming a through hole in the glass of only at a portion between the land where the through electrode of the back surface is provided and the land corresponding to the front surface thereof; a step for filling the through hole with a conductive material; a step for forming a metal layer on the back surface; and a step for polishing the metal layer on the front and back surfaces of the glass until a glass surface is exposed.

The invention according to claim 4 is that, in the manufacturing method for forming a wiring board provided with a through electrode according to claim 3, the step for filling the through hole of the wiring board with the conductive material is characterized in that only an inside portion of the through hole is selectively embedded with a build up method by using electrolytic plating.

The invention according to claim 4 is that the manufacturing method for forming a wiring board provided with a through electrode according to either claim 3 or 4 is characterized in that, in the wiring board, a principal component of a through electrode portion is either Cu, Ag, Au, Ni, Pt, Pd, Ru, Fe or a compound containing these metals.

The invention according to claim 6 is a semiconductor device characterized in that a semiconductor element is disposed, by using the wiring board provided with a through hole according to claim 1, on uppermost surface layer of the board.

### [Advantageous Effects of Invention]

According to the wiring board of the present invention, a wiring board having high adhesion of the wirings even though the base material is a glass, and high reliability without any voids in the through electrode portion, can be produced easily.

In other words, according to the wiring board provided with a through electrode of the present invention, portions of the wiring and the land for both front and back surfaces are processed and then the metal layer is embedded thereto so that the wiring layer of the first layer is incorporated internally. Hence, adhesion can be significantly enhanced and further, the whole surface excluding the surface of the wirings is adhered to the glass, thereby having high adherence even without preprocessing, and improving the reliability when handling.

According to the manufacturing method of the present invention, a blind-via filling is employed for the formation method of TGV, having a structure capable of performing electrolytic plating. Since the seed layer exists in the bottom portion of the via because of the metal layer being formed on one surface, the plating can be proceeded from the via bottom with a build-up method when performing the electrolytic plating. Therefore, filling can be performed without plating focusing on the opening portion so that the TGV without any voids can be formed easily and with high reliability and excellent electrical characteristics can be achieved.

As a principal component of the through electrode, either Cu, Ag, Au, Ni, Pt, Pd, Ru, Fe or a compound containing these metals are used, whereby a simple substance or an alloy can readily be proceed by plating so that excellent electrical characteristics can be secured.

Further, since the wiring board provided with a through electrode of the present invention is capable of mounting a semiconductor element or being mounted to a printed wiring board, when being used as a semiconductor device, excellent electronic characteristics such as fast transmission characteristics can be obtained because the wiring layers are connected by the through electrode. Furthermore, a structure having wirings formed internally contributes to downsizing of electronic equipment.

### [Brief Description of Drawings]

[Fig. 1] is a conceptual diagram showing a cross section of a major portion of a wiring board with a through electrode according to an embodiment of the present invention.
[Fig. 2A] is a conceptual diagram showing a cross section of a major portion in order to explain a procedure of a manufacturing method of the wiring board with the through electrode according to an embodiment of the present invention.
[Fig. 2B] is a conceptual diagram showing a cross section of a major portion in order to explain a procedure of a manufacturing method of the wiring board with the through electrode according to an embodiment of the present invention.
[Fig. 2C] is a conceptual diagram showing a cross section of a major portion in order to explain a procedure of a manufacturing method of the wiring board with the through electrode according to an embodiment of the present invention.
[Fig. 2D] is a conceptual diagram showing a cross section of a major portion in order to explain a procedure of a manufacturing method of the wiring board with the through electrode according to an embodiment of the present invention.
[Fig. 2E] is a conceptual diagram showing a cross section of a major portion in order to explain a procedure of a manufacturing method of the wiring board with the through electrode according to an embodiment of the present invention.
[Fig. 2F] is a conceptual diagram showing a cross section of a major portion in order to explain a procedure of a manufacturing method of the wiring board with the through electrode according to an embodiment of the present invention.
[Fig. 3A] is a conceptual diagram showing a cross section of a major portion in order to explain a procedure of a manufacturing method of the wiring board with the through electrode according to an embodiment of the present invention.
[Fig. 3B] is a conceptual diagram showing a cross section of a major portion in order to explain a procedure of a manufacturing method of the wiring board with the through electrode according to an embodiment of the present invention.
[Fig. 3C] is a conceptual diagram showing a cross section of a major portion in order to explain a procedure of a manufacturing method of the wiring board with the through electrode according to an embodiment of the present invention.
[Fig. 3D] is a conceptual diagram showing a cross section of a major portion in order to explain a procedure of a manufacturing method of the wiring board with the through electrode according to an embodiment of the present invention.
[Fig. 3E] is a conceptual diagram showing a cross section of a major portion in order to explain a procedure of a manufacturing method of the wiring board with the through electrode according to an embodiment of the present invention.
[Fig. 4A] is a conceptual diagram showing a cross section of a major portion in order to explain a procedure for forming a wiring layer of a second layer.
[Fig. 4B] is a conceptual diagram showing a cross section of a major portion in order to explain a procedure for forming a wiring layer of a second layer.
[Fig. 4C] is a conceptual diagram showing a cross section of a major portion in order to explain a procedure for forming a wiring layer of a second layer.
[Fig. 4D] is a conceptual diagram showing a cross section of a major portion in order to explain a procedure for forming a wiring layer of a second layer.
[Fig. 4E] is a conceptual diagram showing a cross section of a major portion in order to explain a procedure for forming a wiring layer of a second layer.
[Fig. 5] is a conceptual diagram showing a cross section of a major portion in order to explain a semiconductor device according to an embodiment of the present invention which employs a glass wiring board with a through electrode as shown in Fig. 1.

### [Description of Embodiments]

With reference to drawings, Hereinafter will be described a wiring board provided with a through electrode, a manufacturing method of the same and a semiconductor device, according to embodiments of the present invention.

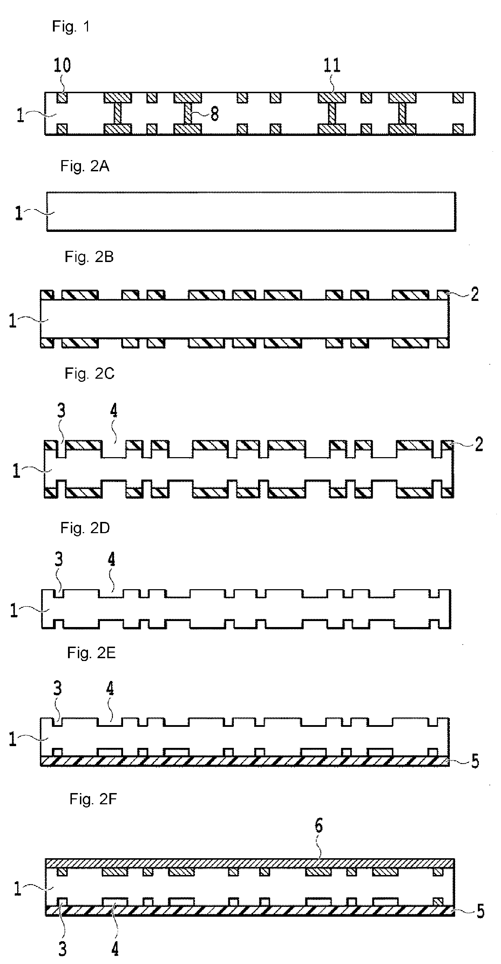

Fig. 1 shows a wiring board provided with a through electrode according to an embodiment of the present invention, in which a wiring 10 and a land 11 in the first layer are formed on the front and back surfaces of a glass 1 as a base material, being embedded in the glass 1. The lands 11 in the first layer embedded in the front and back surfaces are connected by a through electrode 8.

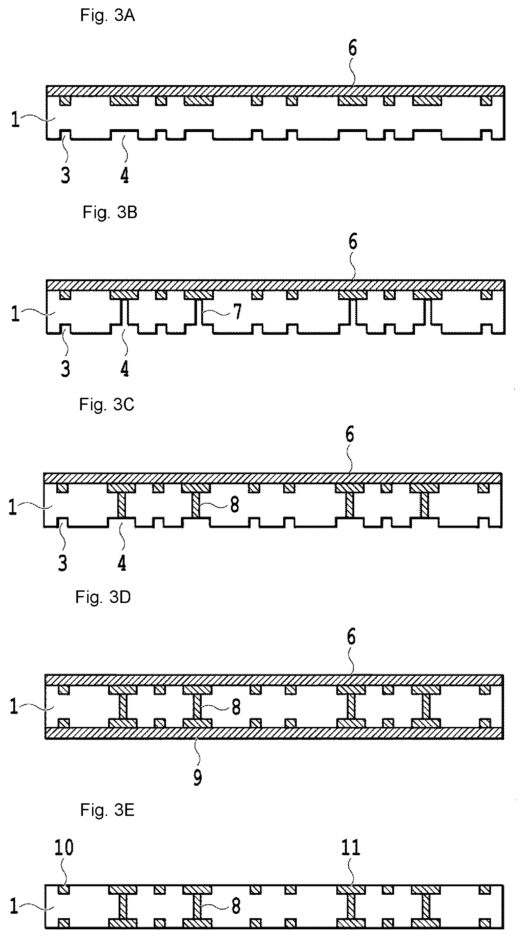

Next, with reference to Figs. 2 and 3, a manufacturing method of the wiring board with a through electrode will be described in detail.

First, a resist 2 is patterned on the glass 1 (Fig. 2A and Fig. 2B). As a formation method, a photolithography is employed. After coating the resist 2 on the whole surface of the glass, it is exposed by using a predetermined mask and developed to remove unnecessary resist, whereby patterning is completed. The resist 2 is preferably formed to be as thick as possible so as to obtain etching selectivity. Also, instead of the resist 2, a method of patterning a metal film such as Al or Ni can be employed. The variety of glass is not specifically limited. For example, quartz glass, borosilicate glass, non-alkali glass or the like can be used.

Next, after patterning the resist 2, as shown in Fig. 2C, a wiring forming portion 3 of the first layer which forms the wiring 10, and a land forming portion 4 of the first layer which becomes the land 11 are formed in the glass 1. As a formation method, dry etching or wet etching can be used. However, the dry etching may preferably be used. This is because wet etching is isotropic, so that etching progresses not only in the vertical direction but also in the horizontal direction. However, dry etching is anisotropic so that selective etching that progresses only in the vertical direction can be performed, which is suitable for forming fine patterns. A gas used for the dry etching is not limited. For example, fluorine-type gas such as HF, CF₄, SF₆ can be used.

After forming the wiring forming portion 3 and the land forming portion 4, as shown in Fig. 2D, the resist 2 which has been patterned is removed. The removal method is not particularly limited. However, when the resist is made of organic material, a remover containing strong alkali or, ashing, can be used to remove the resist. When metal is used, for Ni, a mixture of sulfuric acid and hydrogen peroxide water or ferric chloride aqueous solution can be used. For Al, a mixture of phosphoric acid, nitric acid and acetic acid can be used.

A metal layer 6 is formed on a surface including the wiring forming portion 3 and the land forming portion 4 according to a procedure as shown in Fig. 2E and Fig. 2F. As a formation method, it is possible to form a seed layer by non-electrolytic plating and the metal layer 6 can be grown by the electrolytic plating. At this moment, a resist 5 is formed in the back surface (refer to Fig. 2E), whereby plating can be selectively performed only on one surface. Also, a seed layer may be formed by a physical method such as sputtering or deposition and the metal layer 6 can be grown. In this case, the seed layer can be formed only on one surface so that a process for forming the resist 5 can be reduced. A metal layer 6 formed on the one surface has weak adhesion to the glass 1. However, since micromachining is applied to the surface of the glass 1, the metal layer 6 does not peel off so easily because of an effect similar to the anchor effect.

To form the blind hole 7, the resist 5 formed on the back surface is removed (Fig. 3A, Fig. 3B). As a formation method of the blind hole 7, a laser can be used. As for a laser used for processing glass, a wavelength is desirable. A laser having long wavelength has low absorption of copper. Hence, by using a carbon dioxide laser, it is possible to selectively penetrate the glass.

The formed blind hole 7 is filled with a conductive substance with the electrolytic plating method so as to form the through electrode 8 (Fig. 3C). At this time, the metal layer 6 is used as an electrode to perform the electrolytic plating, whereby plating is proceeded from a bottom portion of the blind hole by the build up method. The plating is sequentially extracted from the via bottom so that an occurrence of voids can be avoided. As a material of the through electrode, copper which has benefits of both cost and excellent electrical characteristics may preferably be used.

After forming the through electrode 8, a metal layer 9 is formed on the back surface portion as shown in Fig. 3D. As a formation method, similar to the metal layer 6, non-electrolytic plating or sputtering is used to grow the seed layer and thereafter, the metal layer 9 can be grown by the electrolytic plating. It is possible to use only non-electrolytic plating or the sputtering to make the metal layer thicker, however, electrolytic plating may preferably be used so as to make the metal layer thicker in a short period of time.

The metal layer 6 and the metal layer 9 which are formed on both surfaces of the glass 1 are polished by CMP (Chemical Mechanical Polishing) or the like, until the glass surface is exposed as shown in Fig. 3E, whereby the wiring 10 and the land 11 in the first layer of the front and back surfaces are embedded in the glass 1. As a result, a wiring board with the glass having the through electrode without any voids can be produced.

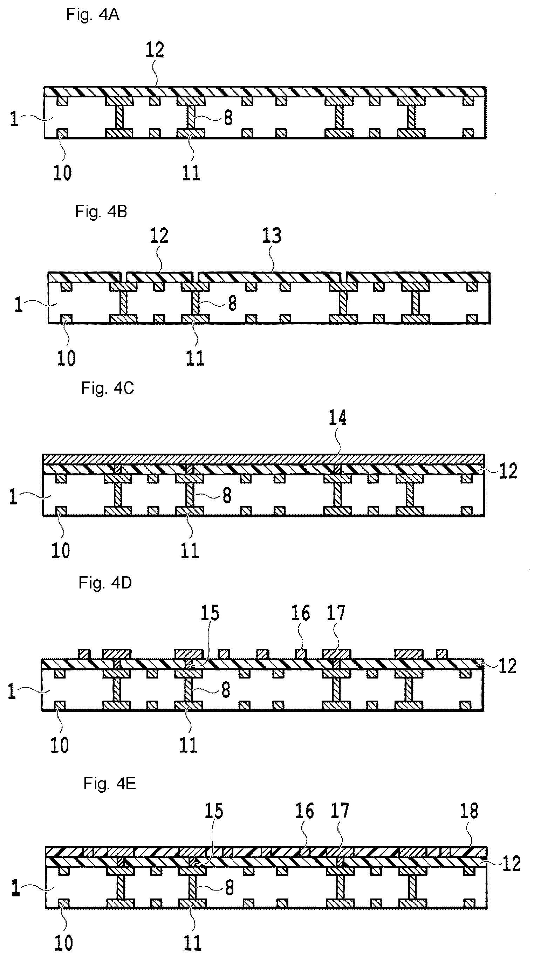

Next, with reference to Fig. 4, a manufacturing method of the wiring layer of the second layer will be described.

An insulation layer 12 is formed on the wiring board (Fig. 4A). For the insulation layer 12, SiO₂ film or Si₃N₄, and polyimide can be used. However, it is not limited to these materials. As a formation method, a CVD method, spin coating and a sol-gel method can be used to form the insulation layer 12.

Next, to connect the wiring board, as shown in Fig.4B, a through hole 13 is provided in the insulation layer 12 by a laser or the like as shown in Fig. 4B. Here, alignment is performed to have only the land 11 of the first layer exposed. The through hole 13 is filled with a conductive material so as to form a metal layer 14 which becomes a wiring layer of the second layer, as shown in Fig. 4C. The metal layer 14 can be formed by plating or a conductive paste. The material thereof is not limited, however, copper may preferably be used considering the manufacturing cost and the electrical characteristics.

Then, the metal layer 14 is etched to form the circuit, thereby forming the wiring layer 16 and the land 17. On this layer, as shown in Fig. 4E, again, an insulation layer 18 is formed whereby a wiring layer of the second layer which is electrically connected to the first layer via the through electrode 15 can be produced.

As for wirings after the second layer, a formation process of the wiring of the second layer is repeatedly performed, whereby the number of wiring layers can be changed freely even for several layers. It should be noted that a manufacturing method only for the wiring of the front surface is described, however, the wiring layer of the back surface is also produced with the same method.

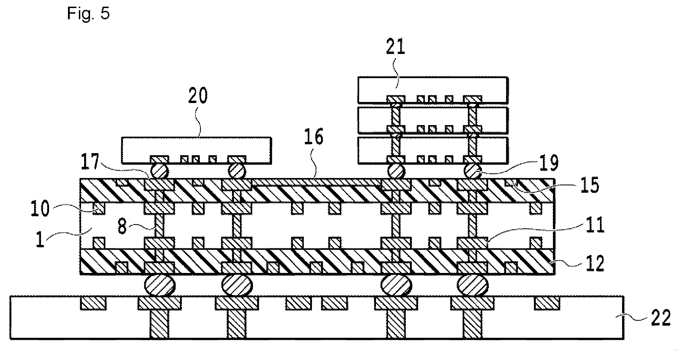

The wiring board provided with the through electrode according to the present invention is used as, for example, an interposer as shown in Fig. 5. That is, a solder ball 19 is used to mount the memory chip 21 on the front surface similarly to the logic chip 20. Similarly, by using the solder ball 19, the back surface is mounted on the printed wiring board 21 so that a glass interposer having a 2.5-dimensional mounting structure can be employed. Since signal communication can be performed between the logic chip 20 and the memory chip 21 on the same surface with short distance and with the through electrodes, a signal can be transmitted to the printed wiring board 22 with the shortest distance, and excellent electrical characteristics are achieved. Also, the base material is made of glass so that expansion and contraction does not occur. Hence, it is possible for it to serve as an interposer provided with a wiring layer having far higher density than a conventional organic resin substrate.

Hereinafter, according to the embodiments of the present invention, examples will be produced and considered.

First, examples for producing the glass wiring board with through electrodes are described. Specifically, non-alkali glass having a thickness of 300 µm is prepared and SU-8 resist (negative epoxy photoresist) having photo setting properties and capable of forming thick film, is formed with thickness 25 µm by a spin coating method. After being exposed using a predetermined mask, patterning is performed with PGMEA (polypropylene glycol methyl ether acetate) as a developer. With a similar method, the back surface is patterned as well.

Next, a dry etching using SF₆ gas is performed so as to form a portion for the wiring and the land on the surface of the glass. As a specification, the width of the wiring portion is 5 µm, the land portion is made as 100 µm square and processed for 20 µm in the depth direction respectively. The back surface is processed similarly. After removing the resist pattern by ashing, a seed layer is formed only on the front surface by copper-sputtering. Then, the processed portion is filled with copper by a copper electroplating. Eventually, the copper is grown until the copper thickness at the surface of the glass becomes 5 µm.

Then, alignment is performed from the back side of the glass and a carbon dioxide laser is irradiated to the land portion so as to form a blind hole having a diameter of 75 µm. Subsequently, the copper film on the front surface is connected to the electrode and filling of the blind hole is performed by copper electroplating so as to form the through electrodes.

Similar to the method for forming the copper film on the front surface, a copper seed layer is formed on the back surface by sputtering and the processed portion is filled by copper electroplating. Finally, the copper formed on the front and back surfaces is polished by CMP until the glass surface is exposed, whereby a wiring board which is capable of being used as a glass interposer having wiring layers with high adhesion and through electrodes without any voids can be produced.

Next, producing the wiring layers subsequent to the second layer is described.

As an insulation layer, the surface is coated with polyimide resin, being applied with 20 µm thickness and a 75 µm hole is made by carbon dioxide laser. Subsequently, electroless copper plating is performed on the through holes and the polyimide so as to form a seed layer, and further a conductive layer with thickness of 10 µm is formed by the copper electroplating. Then, circuit is formed on the conductive layer with a photolithography.

By coating the polyimide resin again to form an insulation layer on the circuit, the wiring layer of the second layer can be formed. In order to form the wiring to be further multi-layered, the above-described method can be repeatedly performed. The back surface thereof can be formed with the same method.

According to the above-described configuration, it was confirmed that a wiring board could be produced in which wirings are adhered on the glass substrate, having through electrodes without any voids.

The present invention is not limited to the above-described embodiments. However, when in the implementation phase, various modifications can be made without departing the scope thereof. Further, the above-described embodiments include inventions in various processes. Therefore, a plurality of disclosed elements are appropriately combined so that various inventions can be obtained.

For example, although some of the elements may be removed from among the all elements disclosed in the embodiments, in a case where issues described in the technical problem section are solved and advantageous effects described in the advantageous effects of the invention are obtained, the elements in which some of the elements are removed can be obtained as an invention.

### [Industrial Applicability]

According to the above-described configuration, a manufacturing method can be utilized for an interposer applicable for high-performance and high-speed electronic equipment using 3-dimensional mounting technology or 2.5-dimensional mounting technology.

### [Reference Signs List]

1: glass
2: resist
3: wiring forming portion
4: land forming portion of first layer
5: resist
6: metal layer
7: blind hole
8: through electrode
9: metal layer
10: wiring of first layer
11: land of first layer
12: insulation layer
13: through hole
14 : metal layer
15: through electrode
16: wiring layer
17: land
18: insulation layer
19: solder ball
20: logic ball
21: memory chip
22: printed wiring board

## Claims

1. A wiring board provided with a through electrode **characterized in that**
the wiring board is multi-layered, having glass as a base material and a through electrode provided in the glass, wherein
a wiring layer and the through electrode in a first layer of front and back surfaces of the base material are formed in the glass.

2. The wiring board provided with a through electrode according to claim 1, **characterized in that**, in the wiring board, a principal component of a through electrode portion is either Cu, Ag, Au, Ni, Pt, Pd, Ru, Fe or a compound containing these metals.

3. A manufacturing method for forming a wiring board provided with a through electrode comprising steps of:
a step for forming, to a first layer, a wiring and a portion for a land where the through electrode is provided, the wiring and the portion for the land being formed in glass;
a step for forming a metal layer on only a front surface of the glass;
a step for forming a through hole in the glass only at a portion between the land where the through electrode of the back surface is provided and the land corresponding to the front surface thereof;
a step for filling the through hole with a conductive material;
a step for forming a metal layer on the back surface; and
a step for polishing the metal layer on the front and back surfaces of the glass until a glass surface is exposed.

4. The manufacturing method for forming a wiring board provided with a through electrode according to claim 3,
the step for filling the through hole of the wiring board with the conductive material is **characterized in that** only an inside portion of the through hole is selectively embedded with a build up method by using electrolytic plating.

5. The manufacturing method for forming a wiring board provided with a through electrode according to either claim 3 or 4, **characterized in that**, in the wiring board, a principal component of a through electrode portion is either Cu, Ag, Au, Ni, Pt, Pd, Ru, Fe or a compound containing these metals.

6. A semiconductor device **characterized in that** a semiconductor element is disposed, by using the wiring board provided with a through hole according to claim 1, on uppermost surface layer of the board.
